# EUROPEAN PATENT SPECIFICATION

(11) **EP 3 955 404 B1**
(45) Date of publication and mention of the grant of the patent: **05.06.2024**
(21) Application number: 20787940.4
(22) Date of filing: 09.04.2020
(51) Int. Cl.: F02B 77/08, H05K 5/02, B29C 45/14

(54) **SEALING STRUCTURE OF CYLINDER PENETRATING WIRE HARNESS**
DICHTUNGSSTRUKTUR FÜR ZYLINDERDURCHDRINGENDEN KABELBAUM
STRUCTURE D'ÉTANCHÉITÉ D'UN FAISCEAU DE CÂBLES PÉNÉTRANT DANS UN CYLINDRE

(30) Priority: 12.04.2019 CN 201910292554
(43) Date of publication of application: 16.02.2022
(73) Proprietor: Mianyang FULIN Precision Co., Ltd., High-end Manufacturing Industrial Park Mianyang Sichuan 621000 (CN)
(72) Inventor: ZHANG, Yang, Mianyang, Sichuan 621000 (CN); ZHANG, Lin, Mianyang, Sichuan 621000 (CN); ZHANG, Jinwei, Mianyang, Sichuan 621000 (CN); WANG, Yan, Mianyang, Sichuan 621000 (CN)
(74) Representative: Ipside
(86) International application number: PCT/CN2020/083921
(87) International publication number: WO 2020/207428

(56) References cited:
- CN-U- 208 571 129
- KR-B1- 100 371 768
- US-A1- 2013 203 284

## Description

### Technical Field

The present invention relates to the field of cylinder penetrating wire harness sealing design, in particular to a cylinder penetrating wire harness sealing structure applied to the engine cylinder body.

### Background of the Invention

For the cylinder penetrating wire harness sealing designs, such as the sealing design of the cylinder penetrating wire harness between a sensor or a controller arranged in an engine cylinder body and a central controller outside the engine cylinder body, the cylinder penetrating wire harness needs to pass through a crankcase or the cylinder body. Therefore, the connection between the wire harness in the engine cylinder body (i.e., "in-cylinder wire harness") and the corresponding wire harness outside the engine cylinder body (i.e., "out-of-cylinder wire harness") needs to be sealed at a connecting part of the engine cylinder body.

According to cylinder penetrating wire harness sealing design solution of the prior art, the out-of-cylinder wire harness is typically in direct connection with the in-cylinder wire harness (alternatively, they are interpreted as an intact wire harness), and the wire harnesses are sealed by means of integrated injection molding of a cylinder penetrating device and the wire harnesses. However, as the cylinder penetrating device and the wire harness rubber sheath are made of different materials, the problem of poor sealing easily occurs between the wire harness rubber sheath and the cylinder penetrating device during the alternative hot operation and cold operation of the engine. In addition, as a multi-strand cable is typically used as a conductor in the wire harness, oil in the engine cylinder body may ascend along or among the multiple strands due to capillarity, thus also resulting in a problem of poor sealing.

A patent application No. US 2013/203284 discloses a device for producing a sealed electrical connection through an engine block crankcase wall in order to connect a sensor or actuating unit contained in the engine block to a central unit comprising a connector provided with at least one bore, which is intended to be arranged in an opening of said wall, at least one electrical contact connected to a wiring harness, said electric contact being surrounded by at least one O-ring seal and arranged in the bore of the connector, said device also comprising an over-moulded part on the wiring harness, an end of the electrical contact connected to the wiring harness and an end of the connector, such that, after the device has been mounted in the opening, the junction between said over-moulded part and the connector is situated on one side of the wall.

Another patent application No. CN 208 571 129 discloses a wear jar connector belongs to automobile manufacturing technical field including a housing body and two spacing holes along the housing body length direction. A cylindric connecting terminal is set in-between the two spacing holes, the connecting terminal is sealed with the inner wall of the spacing holes. The cylindric connecting terminal and wire harness are crimped together.

### Summary of the Invention

The technical problem to be solved by the invention is to provide a cylinder penetrating wire harness sealing structure for the problems of the prior art to improve the sealing performance between the cylinder penetrating wire harness and the cylinder body.

The technical problem to be solved by the invention is realized by the following technical solution: a sealing structure of a cylinder penetrating wire harness comprising an in-cylinder wire harness, a cylinder penetrating device, a cylinder body, a wire connecting sleeve, an out-of-cylinder wire harness and an inner sealing member, wherein the in-cylinder wire harness and the out-of-cylinder wire harness are separately in conductive connection with the wire connecting sleeve; the wire connecting sleeve is arranged in a positioning inner hole in the inner sealing member and the wire connecting sleeve is in sealed connection with the inner sealing member; the inner sealing member is arranged in a cylinder penetrating device inner hole in the cylinder penetrating device and the inner sealing member is in sealed connection with the cylinder penetrating device; and the cylinder penetrating device is in sealed connection with the cylinder body.

Preferably, a positioning groove is configured on the cylinder penetrating device, a sealing ring is arranged in the positioning groove, and a contact sealing structure is formed between the sealing ring and the cylinder body.

Preferably, a limiting shoulder is formed on one end of the cylinder penetrating device, and a contact sealing structure is formed between the limiting shoulder and the cylinder body.

Preferably, the cylinder penetrating device inner hole in the cylinder penetrating device is in tapered structure, one end of the inner sealing member forms a guide part in tapered structure, and a contact sealing structure is formed between the guide part and the cylinder penetrating device inner hole.

Preferably, a blind hole is configured on the wire connecting sleeve, and one end of the in-cylinder wire harness and/or one end of the out-of-cylinder wire harness is inserted into the blind hole on the wire connecting sleeve.

Preferably, the positioning inner hole in the inner sealing member is in stepped structure, the wire connecting sleeve is in stepped shaft structure, and an embedded sealing structure is formed between the wire connecting sleeve and the inner sealing member.

Preferably, the sealing structure of the cylinder penetrating wire harness further comprises a understood that the drawings described below only show some embodiments of the invention, and they shall not be construed as restriction to the scope. Those of ordinary skill in the art can also obtain other figures based on those figures without creative work.
Fig. 1 is a longitudinal sectional view of a sealing structure of a cylinder penetrating wire harness of the present invention (with a protective casing).
Fig. 2 is a longitudinal sectional view of a sealing structure of a cylinder penetrating wire harness of the present invention (without a protective casing).
Fig. 3 is a sectional view of a connection assembly between the in-cylinder wire harness, the out-of-cylinder wire harness and the wire connecting sleeve in Fig. 1 or Fig. 2.
Fig. 4 is a sectional view of the cylinder penetrating device in Fig. 1 or Fig. 2.
Fig. 5 is a sectional view of the inner sealing member in Fig. 1 or Fig. 2.

Marks in the figures: 1- protective casing, 2- in-cylinder wire harness, 3- cylinder penetrating device, 4- sealing ring, 5- cylinder body, 6- wire connecting sleeve, 7- out-of-cylinder wire harness, 8- inner sealing member, 31- positioning groove, 32- cylinder penetrating device inner hole, 33- limiting shoulder, 81- positioning inner hole, 82- guide part.

### Detailed Description of Embodiments

The invention will be described in further detail in combination with drawings and embodiments for clear understanding of the object, technical solution and advantages of the invention. It should be understood that various embodiments described herein are merely used to explain the present invention.

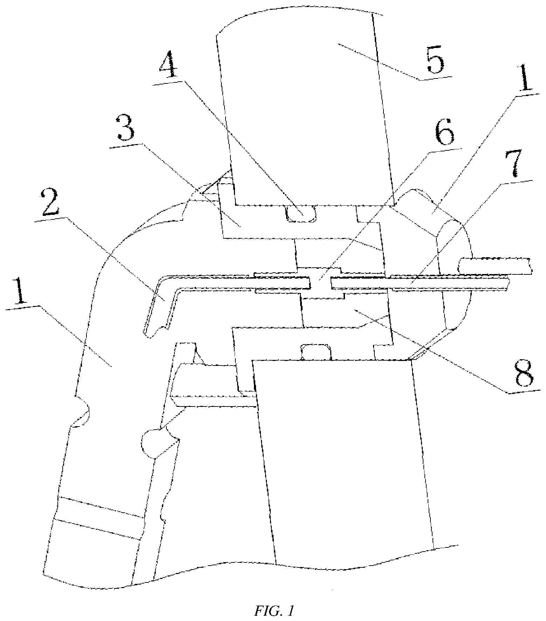

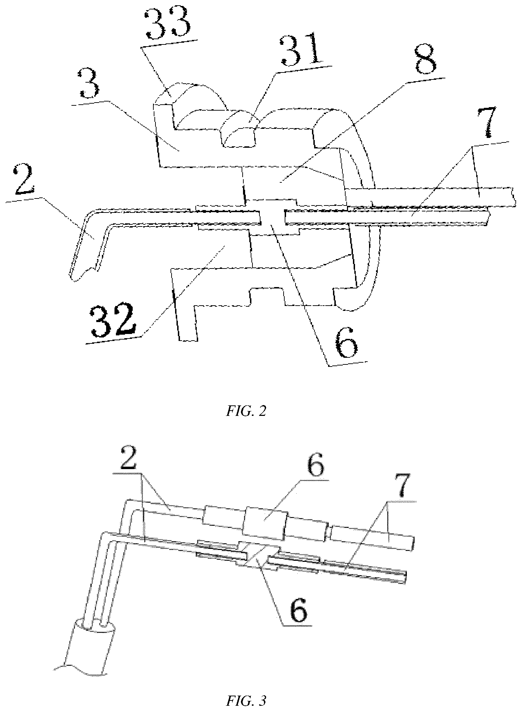

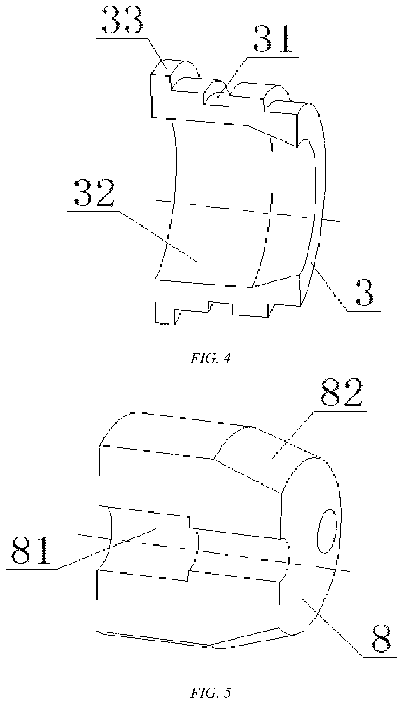

As shown in Fig. 1, Fig. 2 and Fig. 3, the sealing structure of the cylinder penetrating wire harness comprises a protective casing 1, an in-cylinder wire harness 2, a cylinder penetrating device 3, a cylinder body 5, a wire connecting sleeve 6, an out-of-cylinder wire harness 7 and an inner sealing member 8. An cylinder penetrating device inner hole 32 is configured in the cylinder penetrating device 3, an inner mounting hole is configured in the cylinder body 5 for fixing the cylinder penetrating device 3, and a positioning inner hole 81 is configured in the inner sealing member 8. The in-cylinder wire harness 2 and the out-of-cylinder wire harness 7 are separately in conductive connection with the wire connecting sleeve 6, the wire connecting sleeve 6 is arranged in the positioning inner hole 81 in the inner sealing member 8, and the wire connecting sleeve 6 is in sealed connection with the inner sealing member 8. Typically, the wire connecting sleeve 6 provides pressure on the positioning inner hole 81 in the inner sealing member 8. As shown in Fig. 5 and Fig. 2, preferably, the positioning inner hole 81 in the inner sealing member 8 is in stepped structure, the wire connecting sleeve 6 is in stepped shaft structure, and an embedded sealing structure is formed between the wire connecting sleeve 6 and the inner sealing member 8, thereby axially orienting the wire connecting sleeve 6 by assembly of the wire connecting sleeve 6 and the inner sealing member 8 together, and limiting the axial location of the wire connecting sleeve 6 in the inner sealing member 8 in an improved manner.

The inner sealing member 8 is arranged in a cylinder penetrating device inner hole 32 in the cylinder penetrating device 3 and the inner sealing member 8 is in sealed connection with the cylinder penetrating device 3. Typically, the inner sealing member 8 is arranged in the cylinder penetrating device inner hole 32 in the cylinder penetrating device 3 in a press fit manner. As shown in Fig. 1, Fig. 2, Fig. 4 and Fig. 5, In order to improve the sealing reliability between the inner sealing member 8 and the cylinder penetrating device 3, the cylinder penetrating device inner hole 32 in the cylinder penetrating device 3 is in tapered structure, and correspondingly, one end of the inner sealing member 8 forms a guide part 82 in tapered structure, and a contact sealing structure is formed between the guide part 82 and the cylinder penetrating device inner hole 32.

A sealing structure is formed among the protective casing 1, the cylinder penetrating device 3 and the cylinder body 5. Typically, the protective casing 1 is made of plastic material with a certain elasticity; a sealing structure is formed among the protective casing 1, the cylinder penetrating device 3 and the cylinder body 5 by means of injection molding, and the connecting part between the protective casing 1 and the cylinder penetrating device 3 is arranged on one side of the cylinder body 5. The in-cylinder wire harness 2 and the out-of-cylinder wire harness 7 are relatively kept in a stationary state relative to the wire connecting sleeve 6 by means of the protective casing 1, thereby ensuring that the in-cylinder wire harness 2 and the out-of-cylinder wire harness 7 are maintained at given positions to avoid damage in electrical connection, such as damage by wire fatigue or damage by vibration or improper treatment.

The cylinder penetrating device 3 is in sealed connection with the cylinder body 5. Typically, the cylinder penetrating device 3 is positioned and arranged in an inner mounting hole in the cylinder body 5. As shown in Fig. 4, to facilitate positioning of the cylinder penetrating device 3 and improve the sealing performance between the cylinder penetrating device 3 and the cylinder body 5, a positioning groove 31 is configured on the cylinder penetrating device 3, a sealing ring 4 is arranged in the positioning groove 31, and a contact sealing structure is formed between the sealing ring 4 and the cylinder body 5. In addition, a limiting shoulder 33 is formed on one end of the cylinder penetrating device 3, and a contact sealing structure is formed between the limiting shoulder 33 and the cylinder body 5. Particularly, the arrangement of sealing ring 4 ensures sealing robustness in thermal shock environment, in particular to sealing reliability in a cold starting process, and in the cases that wire sheaths of the in-cylinder wire harness 2 and the out-of-cylinder wire harness 7 are penetrated, such as the penetration during the injection molding of the protective casing 1 or the use of the engine cylinder body, the sealing reliability of the in-cylinder wire harness 2 and the out-of-cylinder wire harness 7 is guaranteed.

According to the present invention, a triple-sealing structure is formed by means of the sealing connection between the wire connecting sleeve 6 and the inner sealing member 8, the sealing connection between the inner sealing member 8 and the cylinder penetrating device 3 and the sealing connection between the cylinder penetrating device 3 and the cylinder body 5, and the leakage caused by permeation, between the in-cylinder wire harness 2 and the out-of-cylinder wire harness 7, of a fluid medium is effectively blocked by the wire connecting sleeve 6, thereby greatly improving the sealing performance between the cylinder penetrating wire harness and the cylinder body 5, and being easy to implement and having low implementation costs. As shown in Fig. 1 to Fig. 3, preferably, blind holes with a typical depth of 10 mm are configured on two ends of the wire connecting sleeve 6. One end of the in-cylinder wire harness 2 and one end of the out-of-cylinder wire harness 7 are inserted into the blind holes on the wire connecting sleeve 6, and then connected and fixed by means of riveting or welding, thereby ensuring reliable connection between the in-cylinder wire harness 2, the out-of-cylinder wire harness 7 and the wire connecting sleeve 6, and effectively preventing leakage by blocking the permeation of a fluid medium (e.g., engine oil) between the in-cylinder wire harness 2 and the out-of-cylinder wire harness 7. Therefore, the problem of fluid medium (e.g., engine oil) ascending along the multi-strand wire harness is solved.

The inner sealing member 8 is arranged in a cylinder penetrating device inner hole 32 in the cylinder penetrating device 3 and does not involve the injection molding of the protective casing 1. As the sealing structure between the cylinder penetrating device 3 and the inner mounting hole in the cylinder body 5 and that between the in-cylinder wire harness 2 and the cylinder penetrating device 3 effectively prevent the leakage, improperly sealed connecting part between an injection-molded part of the protective casing 1 and the cylinder penetrating device 3 will not cause the sealing problem. As the inner sealing member 8 is not an injection-molded part, the injection pressure for injection molding is capable of being reduced. In addition, non-essential use of the in-cylinder wire harness 2 and the out-of-cylinder wire harness 7 with high-quality overmolded rubber sheath is avoid, thereby reducing the purchasing cost of the in-cylinder wire harness 2 and the out-of-cylinder wire harness 7. As the present invention does not ensure the sealing reliability by the conventional injection molding method, the management of injection molding steps of the protective casing 1 is not critical, the implementation of injection molding is less dependent on precision, and the injection molding steps are simplified for higher efficiency, thereby simplifying the injection mold and further reducing the fabricating cost. Therefore, the present invention is easy to carry out at low cost.

The invention is limited only by the appended claims.

## Claims

1. A sealing structure of a cylinder penetrating wire harness, comprising an in-cylinder wire harness (2), a cylinder body (5) and an out-of-cylinder wire harness (7), wherein
the sealing structure of the cylinder penetrating wire harness further comprises a cylinder penetrating device (3) in sealed connection with the cylinder body (5), **characterised by** a wire connecting sleeve (6) and an inner sealing member (8), wherein
the in-cylinder wire harness (2) and the out-of-cylinder wire harness (7) are separately in conductive connection with the wire connecting sleeve (6); the wire connecting sleeve (6) is arranged in a positioning inner hole (81) in the inner sealing member (8) and the wire connecting sleeve (6) is in sealed connection with the inner sealing member (8); the inner sealing member (8) is arranged in a cylinder penetrating device inner hole (32) in the cylinder penetrating device (3) and the inner sealing member (8) is in sealed connection with the cylinder penetrating device (3).

2. The sealing structure of the cylinder penetrating wire harness according to claim 1, **characterized in that** a positioning groove (31) is configured on the cylinder penetrating device (3), a sealing ring (4) is arranged in the positioning groove (31), and a contact sealing structure is formed between the sealing ring (4) and the cylinder body (5).

3. The sealing structure of the cylinder penetrating wire harness according to claim 1, **characterized in that** a limiting shoulder (33) is formed on one end of the cylinder penetrating device (3), and a contact sealing structure is formed between the limiting shoulder (33) and the cylinder body (5).

4. The sealing structure of the cylinder penetrating wire harness according to claim 1, **characterized in that** the cylinder penetrating device inner hole (32) in the cylinder penetrating device (3) is in tapered structure, one end of the inner sealing member (8) forms a guide part (82) in tapered structure, and a contact sealing structure is formed between the guide part (82) and the cylinder penetrating device inner hole (32).

5. The sealing structure of the cylinder penetrating wire harness according to claim 1, **characterized in that** a blind hole is configured on the wire connecting sleeve (6), and one end of the in-cylinder wire harness (2) and/or one end of the out-of-cylinder wire harness (7) is inserted into the blind hole on the wire connecting sleeve (6).

6. The sealing structure of the cylinder penetrating wire harness according to claim 1, **characterized in that** the positioning inner hole (81) in the inner sealing member (8) is in stepped structure, the wire connecting sleeve (6) is in stepped shaft structure, and an embedded sealing structure is formed between the wire connecting sleeve (6) and the inner sealing member (8).

7. The sealing structure of the cylinder penetrating wire harness according to any of claims 1 to 6, **characterized by** further comprising a protective casing (1), and a sealing structure is formed among the protective casing (1), the cylinder penetrating device (3) and the cylinder body (5), wherein the connecting part between the protective casing (1) and the cylinder penetrating device (3) is arranged on one side of the cylinder body (5).

8. The sealing structure of the cylinder penetrating wire harness according to claim 7, **characterized in that** a sealing structure is formed among the protective casing (1), the cylinder penetrating device (3) and the cylinder body (5) by means of injection molding.

## Patentansprüche

1. Dichtungsstruktur eines zylinderdurchdringenden Kabelbaums, umfassend einen zylinderinternen Kabelbaum (2), einen Zylinderkörper (5) und einen zylinderexternen Kabelbaum (7), wobei die Dichtungsstruktur des zylinderdurchdringenden Kabelbaums ferner eine zylinderdurchdringende Vorrichtung (3) in abgedichteter Verbindung mit dem Zylinderkörper (5) umfasst, **gekennzeichnet durch** eine Drahtverbindungshülse (6) und ein inneres Dichtungselement (8), wobei
der zylinderinterne Kabelbaum (2) und der zylinderexterne Kabelbaum (7) separat in leitender Verbindung mit der Drahtverbindungshülse (6) stehen; die Drahtverbindungshülse (6) in einem Positionierungsinnenloch (81) im inneren Dichtungselement (8) angeordnet ist und die Drahtverbindungshülse (6) in abgedichteter Verbindung mit dem inneren Dichtungselement (8) steht; das innere Dichtungselement (8) in einem Innenloch (32) der zylinderdurchdringenden Vorrichtung in der zylinderdurchdringenden Vorrichtung (3) angeordnet ist und das innere Dichtungselement (8) in abgedichteter Verbindung mit der zylinderdurchdringenden Vorrichtung (3) steht.

2. Dichtungsstruktur des zylinderdurchdringenden Kabelbaums nach Anspruch 1, **dadurch gekennzeichnet, dass** eine Positionierungsnut (31) an der zylinderdurchdringenden Vorrichtung (3) konfiguriert ist, ein Dichtungsring (4) in der Positionierungsnut (31) angeordnet ist und eine Kontaktdichtungsstruktur zwischen dem Dichtungsring (4) und dem Zylinderkörper (5) ausgebildet ist.

3. Dichtungsstruktur des zylinderdurchdringenden Kabelbaums nach Anspruch 1, **dadurch gekennzeichnet, dass** eine Begrenzungsschulter (33) an einem Ende der zylinderdurchdringenden Vorrichtung (3) ausgebildet ist, und eine Kontaktdichtungsstruktur zwischen der Begrenzungsschulter (33) und dem Zylinderkörper (5) ausgebildet ist.

4. Dichtungsstruktur des zylinderdurchdringenden Kabelbaums nach Anspruch 1, **dadurch gekennzeichnet, dass** das Innenloch (32) der zylinderdurchdringenden Vorrichtung in der zylinderdurchdringenden Vorrichtung (3) eine konische Struktur aufweist, wobei ein Ende des inneren Dichtungselements (8) einen Führungsteil (82) mit konischer Struktur bildet, und eine Kontaktdichtungsstruktur zwischen dem Führungsteil (82) und dem Innenloch (32) der zylinderdurchdringenden Vorrichtung ausgebildet ist.

5. Dichtungsstruktur des zylinderdurchdringenden Kabelbaums nach Anspruch 1, **dadurch gekennzeichnet, dass** ein Sackloch an der Kabelverbindungshülse (6) konfiguriert ist, und ein Ende des zylinderinternen Kabelbaums (2) und/oder ein Ende des zylinderexternen Kabelbaums (7) in das Sackloch an der Kabelverbindungshülse (6) eingeführt ist.

6. Dichtungsstruktur des zylinderdurchdringenden Kabelbaums nach Anspruch 1, **dadurch gekennzeichnet, dass** das Positionierungsinnenloch (81) im inneren Dichtungselement (8) eine abgestufte Struktur aufweist, die Kabelverbindungshülse (6) einen Schaft mit abgestufter Struktur aufweist, und eine eingebettete Dichtungsstruktur zwischen der Drahtverbindungshülse (6) und dem inneren Dichtungselement (8) ausgebildet ist.

7. Dichtungsstruktur des zylinderdurchdringenden Kabelbaums nach einem der Ansprüche 1 bis 6, **dadurch gekennzeichnet, dass** sie ferner ein Schutzgehäuse (1) umfasst, und eine Dichtungsstruktur zwischen dem Schutzgehäuse (1), der zylinderdurchdringenden Vorrichtung (3) und dem Zylinderkörper (5) ausgebildet ist, wobei das Verbindungsteil zwischen dem Schutzgehäuse (1) und der zylinderdurchdringenden Vorrichtung (3) auf einer Seite des Zylinderkörpers (5) angeordnet ist.

8. Dichtungsstruktur des zylinderdurchdringenden Kabelbaums nach Anspruch 7, **dadurch gekennzeichnet, dass** eine Dichtungsstruktur zwischen dem Schutzgehäuse (1), der zylinderdurchdringenden Vorrichtung (3) und dem Zylinderkörper (5) durch Spritzgussfertigung ausgebildet ist.

## Revendications

1. Structure d'étanchéité d'un faisceau de câbles traversant un cylindre, comprenant un faisceau de câbles intra-cylindre (2), un corps de cylindre (5) et un faisceau de câbles hors cylindre (7), dans laquelle la structure d'étanchéité du faisceau de câbles traversant un cylindre comprend en outre un dispositif traversant un cylindre (3) en liaison étanche avec le corps de cylindre (5), **caractérisée par** un manchon de liaison de câbles (6) et un élément d'étanchéité interne (8), dans laquelle
le faisceau de câbles intra-cylindre (2) et le faisceau de câbles hors cylindre (7) sont séparément en liaison conductrice avec le manchon de liaison de câbles (6) ; le manchon de liaison de câbles (6) est agencé dans un trou interne de positionnement (81) dans l'élément d'étanchéité interne (8) et le manchon de liaison de câbles (6) est en liaison étanche avec l'élément d'étanchéité interne (8) ; l'élément d'étanchéité interne (8) est agencé dans un trou interne (32) de dispositif traversant un cylindre dans le dispositif traversant un cylindre (3) et l'élément d'étanchéité interne (8) est en liaison étanche avec le dispositif traversant un cylindre (3).

2. Structure d'étanchéité du faisceau de câbles traversant un cylindre selon la revendication 1, **caractérisée en ce qu'**une rainure de positionnement (31) est configurée sur le dispositif traversant un cylindre (3), une bague d'étanchéité (4) est agencée dans la rainure de positionnement (31), et une structure d'étanchéité par contact est formée entre la bague d'étanchéité (4) et le corps de cylindre (5).

3. Structure d'étanchéité du faisceau de câbles traversant un cylindre selon la revendication 1, **caractérisée en ce qu'**un épaulement de limitation (33) est formé sur une extrémité du dispositif traversant un cylindre (3), et une structure d'étanchéité par contact est formée entre l'épaulement de limitation (33) et le corps de cylindre (5).

4. Structure d'étanchéité du faisceau de câbles traversant un cylindre selon la revendication 1, **caractérisée en ce que** le trou interne (32) de dispositif traversant un cylindre dans le dispositif traversant un cylindre (3) présente une structure conique, une extrémité de l'élément d'étanchéité interne (8) forme une partie de guidage (82) présentant une structure conique, et une structure d'étanchéité par contact est formée entre la partie de guidage (82) et le trou interne (32) de dispositif traversant un cylindre.

5. Structure d'étanchéité du faisceau de câbles traversant un cylindre selon la revendication 1, **caractérisée en ce qu'**un trou borgne est configuré sur le manchon de liaison de câbles (6), et une extrémité du faisceau de câbles intra-cylindre (2) et/ou une extrémité du faisceau de câbles hors cylindre (7) sont insérées dans le trou borgne du manchon de liaison de câbles (6).

6. Structure d'étanchéité du faisceau de câbles traversant un cylindre selon la revendication 1, **caractérisée en ce que** le trou interne de positionnement (81) dans l'élément d'étanchéité interne (8) présente une structure étagée, le manchon de liaison de câbles (6) présente une structure d'axe étagé, et une structure d'étanchéité intégrée est formée entre le manchon de liaison de câbles (6) et l'élément d'étanchéité interne (8).

7. Structure d'étanchéité du faisceau de câbles traversant un cylindre selon l'une quelconque des revendications 1 à 6, **caractérisée en ce qu'**elle comprend en outre un boîtier protecteur (1), et une structure d'étanchéité est formée entre le boîtier protecteur (1), le dispositif traversant un cylindre (3) et le corps de cylindre (5), dans laquelle la partie de liaison entre le boîtier protecteur (1) et le dispositif traversant un cylindre (3) est agencée d'un côté du corps de cylindre (5).

8. Structure d'étanchéité du faisceau de câbles traversant un cylindre selon la revendication 7, **caractérisée en ce qu'**une structure d'étanchéité est formée entre le boîtier protecteur (1), le dispositif traversant un cylindre (3) et le corps de cylindre (5) par moulage par injection.
